# EUROPEAN PATENT APPLICATION

(11) **EP 4 746 678 A1**
(43) Date of publication of application: **20.05.2026**
(21) Application number: 25209035.2
(22) Date of filing: 16.10.2025
(51) Int. Cl.: H10W 72/20, H10W 90/00, H10W 70/652, H10W 70/654, H10W 70/65, H10W 70/685

(54) **SEMICONDUCTOR PACKAGE INCLUDING BUMP**

(30) Priority: 19.11.2024 KR 20240164785
(71) Applicant: SK hynix Inc., Bubal-eub Icheon-si Gyeonggi-do 17336 (KR)
(72) Inventor: PARK, Wan Choon, 17336 Icheon-si, Gyeonggi-do (KR); LEE, Hyo Sun, 17336 Icheon-si, Gyeonggi-do (KR)
(74) Representative: Isarpatent

(57) **Abstract**

A semiconductor package includes a wiring structure, a first bump, and a semiconductor chip. The wiring structure includes a first electrode and has a first surface and a second surface that faces away from the first surface. The second surface of the wiring structure includes a recessed area that overlaps the first electrode. The first bump includes a first conductive pillar on the first surface of the wiring structure and a first solder layer on the first conductive pillar. The first bump contacts the first electrode. The first electrode includes a first section and a second section. The first section of the first electrode is disposed between the first surface of the wiring structure and the second surface of the wiring structure. The second section of the first electrode has a lower surface that is included in the first surface of the wiring structure. The horizontal width of the first conductive pillar is less than the horizontal width of the first electrode. A semiconductor chip is disposed above the second surface of the wiring structure.

## Description

### CROSS-REFERENCE TO RELATED APPLICATION

The present application claims priority to Korean Patent Application No. 10-2024-0164785 filed in the Korean Intellectual Property Office on November 19, 2024, the entire contents of which application is incorporated herein by reference in its entirety.

### BACKGROUND

### 1. Technical Field

Some embodiments of the present disclosure relate to a semiconductor package including a bump and a method of forming the same.

### 2. Related Art

In response to the miniaturization of semiconductor packages, technologies utilizing a redistribution layer and bumps are being attempted. The redistribution layer provides connections between a semiconductor chip and external components. The redistribution layer includes an insulating layer and wirings formed in the insulating layer. The bumps on the redistribution layer are connected to the wirings.

### SUMMARY

In an embodiment, a semiconductor package includes a package substrate, a wiring structure on the package substrate, a first bump, and semiconductor chip. The wiring structure includes a first electrode and has a first surface and a second surface that faces away from the first surface. The second surface of the wiring structure includes a recessed area that overlaps the first electrode. The first electrode includes a first section and a second section. The first section of the first electrode is disposed between the first surface of the wiring structure and the second surface of the wiring structure. The second section of the first electrode has a lower surface that is included in the first surface of the wiring structure. The first bump is disposed between the first surface of the wiring structure and the package substrate. The first bump contacts the first electrode. The first bump includes a first conductive pillar on the first surface of the wiring structure and a first solder layer on the first conductive pillar. The horizontal width of the first conductive pillar is less than the horizontal width of the first electrode. The semiconductor chip is disposed over the second surface of the wiring structure.

In an embodiment, a semiconductor package includes a wiring structure, a first bump, and a semiconductor chip. The wiring structure includes a first electrode and has a first surface and a second surface that faces away from the first surface. The second surface of the wiring structure includes a recessed area that overlaps the first electrode. The first electrode includes a first section and a second section. The first section of the first electrode is disposed between the first surface of the wiring structure and the second surface of the wiring structure. The second section of the first electrode has a lower surface that is included in the first surface of the wiring structure. The first bump is disposed on the first surface of the wiring structure and contacts the first electrode. The first bump includes a first conductive pillar on the first surface of the wiring structure and a first solder layer on the first conductive pillar. The horizontal width of the first conductive pillar is less than the horizontal width of the first electrode. The semiconductor chip is disposed over the second surface of the wiring structure.

In an embodiment, a semiconductor package includes a wiring structure having a first surface and a second surface that faces away from the first surface. The wiring structure includes a first insulating layer, a second insulating layer between the first insulating layer and the second surface of the wiring structure, and a first electrode between the first insulating layer and the second insulating layer, wherein the first surface of the wiring structure includes the lower surface of the first insulating layer. The semiconductor package further includes a first bump on the first surface of the wiring structure, a semiconductor chip over the second surface of the wiring structure, and a second bump between the wiring structure and the semiconductor chip. The first electrode penetrates through the first insulating layer and contacts the first bump. The second section of the first electrode has a ring shape. The first bump includes a first conductive pillar on the first electrode and a first solder layer on the first conductive pillar. The first conductive pillar electrically contacts the second section of the first electrode, and the first conductive pillar has a horizontal width less than the outer diameter of the second section of the first electrode.

### BRIEF DESCRIPTION OF THE DRAWINGS

FIG. 1 is a cross-sectional view of a semiconductor package according to an embodiment of the present disclosure.
FIG. 2 is a partial view illustrating a partial configuration of FIG. 1.
FIG. 3 to FIG. 5 are cross-sectional views of semiconductor packages according to embodiments of the present disclosure.
FIG. 6 to FIG. 11 are plan views of semiconductor packages according to embodiments of the present disclosure.
FIG. 12 is a cross-sectional view of a semiconductor package according to an embodiment of the present disclosure.
FIG. 13 is a partial view illustrating a partial configuration of FIG. 12.
FIG. 14 to FIG. 16 are plan views of semiconductor packages according to embodiments of the present disclosure.
FIG. 17 is a cross-sectional view of a semiconductor package according to an embodiment of the present disclosure.
FIG. 18 is a partial view illustrating a partial configuration of FIG. 17.
FIG. 19 is a plan view of a semiconductor package according to an embodiment of the present disclosure.
FIG. 20 and FIG. 21 are cross-sectional views of semiconductor packages according to embodiments of the present disclosure.
FIG. 22 to FIG. 34 are cross-sectional views for describing a method of forming a semiconductor package according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the specific examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through one or more intervening elements. When two elements are identified as "directly connected" or "directly coupled," one element is directly connected or directly coupled to the other element without an intervening element.

When one element is identified as "on," "over," or "under," another element, the elements may directly contact each other or one or more intervening elements may be disposed between the elements.

Terms such as "horizontal," "bottom," "above," "under," "over," "on," "side," "upper," "lower," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

Some embodiments of the present disclosure are directed to a semiconductor package with improved reliability. Other embodiments are directed to a method of forming a semiconductor package with improved reliability.

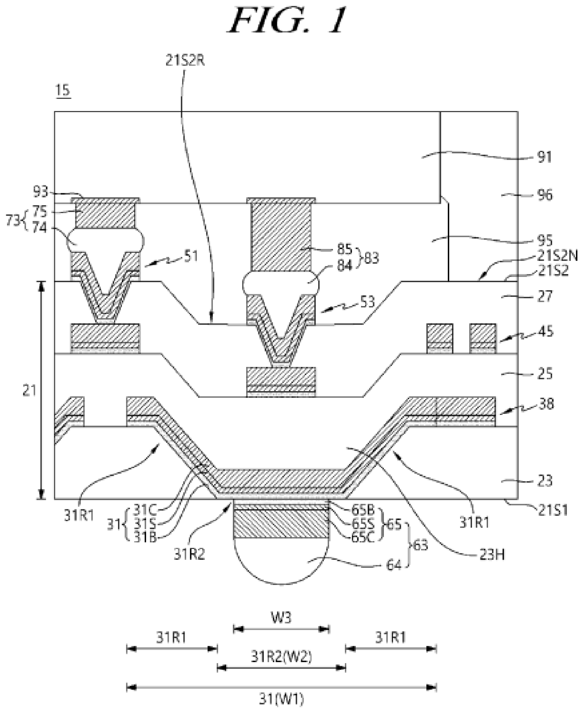

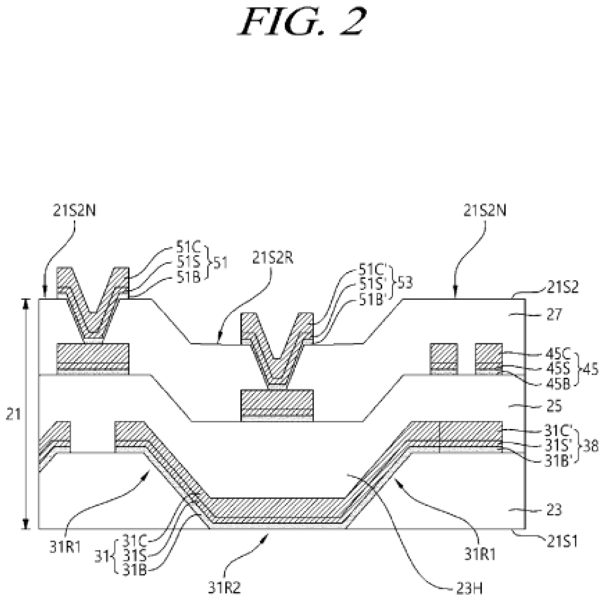

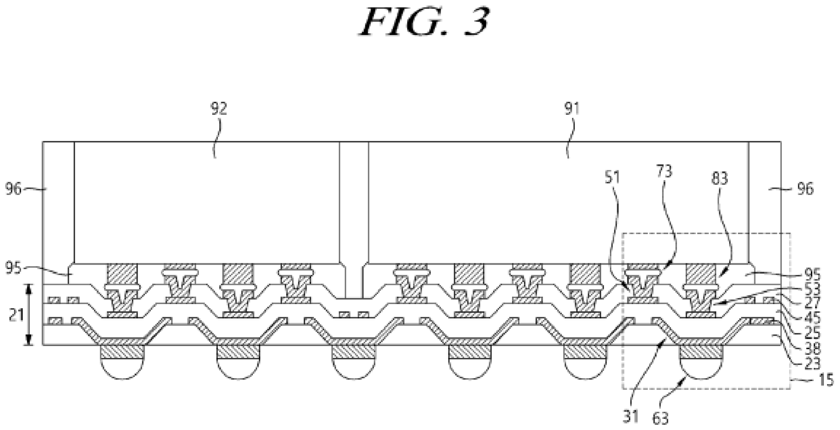

FIG. 1 is a cross-sectional view of a semiconductor package according to an embodiment of the present disclosure, and FIG. 2 is a partial view illustrating a partial configuration of FIG. 1. FIG. 3 is a cross-sectional view of a semiconductor package according to an embodiment of the present disclosure. In an embodiment, FIG. 1 is a partial view illustrating a part 15 of FIG. 3.

Referring to FIG. 1, a semiconductor package according to an embodiment of the present disclosure includes a wiring structure 21, a first bump 63, a second bump 73, a third bump 83, a first semiconductor chip 91, an underfill 95, and a first encapsulant 96. In an embodiment, the wiring structure 21 includes a multi-layer redistribution layer (MLR).

The wiring structure 21 may include a first insulating layer 23, a second insulating layer 25, a third insulating layer 27, a first electrode 31, a first wiring 38, a second wiring 45, a second electrode 51, and a third electrode 53. The first electrode 31 may include a first barrier layer 31B, a first seed layer 31S, and a first conductive layer 31C. The first electrode 31 may include a first section 31R1 that overlaps the first insulating layer 23 and a second section 31R2 that does not overlap the first insulating layer 23.

The wiring structure 21 may include a first surface 21S1 and a second surface 21S2. The second surface 21S2 of the wiring structure 21 may include a flat area 21S2N and a recessed area 21S2R. The wiring structure 21 is described in detail with reference to FIG. 2. The recessed area 21S2R may overlap the first bump 63.

The first bump 63 may be disposed on the first surface 21S1 of the wiring structure 21. The first electrode 31 may be disposed on the first surface 21S1 of the wiring structure 21. The first bump 63 may contact a surface of the first electrode 31. For example, the first electrode 31 has a first surface that contacts the first bump 63 and a second surface that faces away from the first surface. In an embodiment, the first bump 63 contacts the lower surface of the second section 31R2 of the first electrode 31. The first bump 63 may include a first conductive pillar 65 and a first solder layer 64. The first conductive pillar 65 may be disposed between the first solder layer 64 and the surface of the first electrode 31 contacted by the first bump 63. In an embodiment, the first conductive pillar 65 contacts the lower surface of the second section 31R2 of the first electrode 31. The first solder layer 64 may be disposed on the lower surface of the first conductive pillar 65.

The first conductive pillar 65 may include a second barrier layer 65B, a second seed layer 65S on the second barrier layer 65B, and a second conductive layer 65C on the second seed layer 65S. The second barrier layer 65B may be disposed between the second seed layer 65S and the second section 31R2 of the first electrode 31. In an embodiment, the second barrier layer 65B contacts the first barrier layer 31B of the second section 31R2 of the first electrode 31. The second conductive layer 65C may be disposed between the first solder layer 64 and the second seed layer 65S.

The horizontal width of the first electrode 31 is a first width W1, designated in FIG. 1 as 31(W1). The horizontal width of the second section 31R2 of the first electrode 31 is a second width W2, designated in FIG. 1 as 31R2(W2). The second width W2 may be less than the first width W1. The horizontal width of the first conductive pillar 65 is a third width W3. The third width W3 may be less than the first width W1. In an embodiment, the third width W3 is less than the second width W2.

The first bump 63 may be overlapped by the second section 31R2 of the first electrode 31. The first bump 63 is not overlapped by the first insulating layer 23. In an embodiment, the first conductive pillar 65 is overlapped by the second section 31R2 of the first electrode 31. The first conductive pillar 65 is not overlapped by the first insulating layer 23.

The first semiconductor chip 91 may be disposed over the second surface 21S2 of the wiring structure 21. The underfill 95 may be disposed between the first semiconductor chip 91 and the wiring structure 21. In an embodiment, the underfill 95 is omitted. The second bump 73 is disposed between the first semiconductor chip 91 and the wiring structure 21. The second bump 73 may be connected to the first semiconductor chip 91 and the second electrode 51. In an embodiment, the second bump 73 contacts a chip pad 93 in the first semiconductor chip 91. The third bump 83 may be disposed between the first semiconductor chip 91 and the wiring structure 21. The third bump 83 may be connected to the first semiconductor chip 91 and the third electrode 53. In an embodiment, the third bump 83 contacts a chip pad 93 in the first semiconductor chip 91. The underfill 95 surrounds the sidewall of the second bump 73 and the sidewall of the third bump 83.

The second bump 73 may include a second solder layer 74 and a second conductive pillar 75. The second solder layer 74 may be disposed between the second conductive pillar 75 and the second electrode 51. The third bump 83 may include a third solder layer 84 and a third conductive pillar 85. The third solder layer 84 may be disposed between the third conductive pillar 85 and the third electrode 53.

The second electrode 51 and the third electrode 53 may be disposed on the second surface 21S2 of the wiring structure 21. The second electrode 51 and the third electrode 53 may penetrate the third insulating layer 27 and contact the second wiring 45. The second electrode 51 may be disposed in the flat area 21S2N of the second surface 21S2 of the wiring structure 21. The third electrode 53 may be disposed in the recessed area 21S2R of the second surface 21S2 of the wiring structure 21. Because the recessed area 21S2R is recessed relative to the flat area 21S2N, the height of the third bump 83 may be greater than the height of the second bump 73. In an embodiment, the height of the third conductive pillar 85 is greater than the height of the second conductive pillar 75.

Referring to FIG. 2, the wiring structure 21 may include the first insulating layer 23, the second insulating layer 25, the third insulating layer 27, the first electrode 31, the first wiring 38, and the second wiring 45. The wiring structure 21 may include the first surface 21S1 and the second surface 21S2 that faces away from the first surface 21S1. The first surface 21S1 of the wiring structure 21 may form a relatively flat surface compared to the second surface 21S2 of the wiring structure 21. The second surface 21S2 of the wiring structure 21 may include relatively large unevenness compared to the first surface 21S1 of the wiring structure 21. In an embodiment, the second surface 21S2 of the wiring structure 21 includes the flat area 21S2N and the recessed area 21S2R. The distance between the recessed area 21S2R and the first surface 21S1 of the wiring structure 21 may be shorter than the distance between the flat area 21S2N and the first surface 21S1 of the wiring structure 21. The recessed area 21S2R of the second surface 21S2 of the wiring structure 21 may overlap the first electrode 31. The center of the recessed area 21S2R may be aligned with the center of the second section 31R2 of the first electrode 31.

The first electrode 31 may include the first barrier layer 31B, the first seed layer 31S on the first barrier layer 31B, and the first conductive layer 31C on the first seed layer 31S. The first electrode 31 may penetrate the first insulating layer 23. The first electrode 31 may include the first section 31R1 that overlaps the first insulating layer 23 and the second section 31R2 that does not overlap the first insulating layer 23. The lower surface of the second section 31R2 of the first electrode 31 may be substantially the same plane as the lower surface of the first insulating layer 23. The lower surface of the first insulating layer 23 together with the lower surface of the second section 31R2 of the first electrode 31 may form the first surface 21S1 of the wiring structure 21. The first surface 21S1 of the wiring structure 21 may be a flat surface.

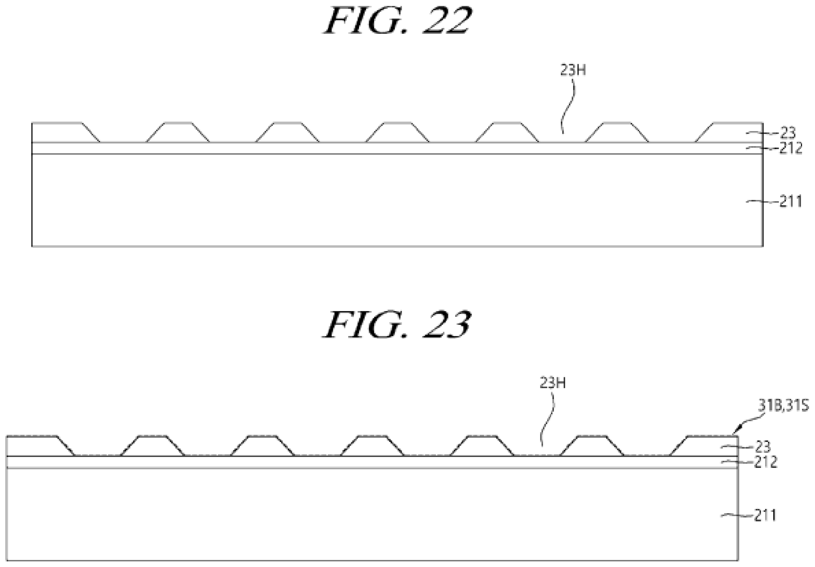

A first opening 23H may penetrate the first insulating layer 23. In the first opening 23H, the inclined surface of the first insulating layer 23 may be exposed. The first opening 23H is described in detail with reference to FIG. 22. The first section 31R1 of the first electrode 31 may extend along the inclined surface of the first insulating layer 23. The first section 31R1 of the first electrode 31 may be disposed between the first insulating layer 23 and the second insulating layer 25. The second section 31R2 of the first electrode 31 may penetrate the first insulating layer 23. The second section 31R2 of the first electrode 31 may be disposed at the bottom of the first opening 23H.

The first wiring 38 may be disposed on the first insulating layer 23. The first wiring 38 may be disposed between the first insulating layer 23 and the second insulating layer 25. The first wiring 38 may contact the side surface of the first section 31R1 of the first electrode 31. Similarly to the first electrode 31, the first wiring 38 may include a first barrier layer 31B', a first seed layer 31S' on the first barrier layer 31B', and a first conductive layer 31C' on the first seed layer 31S'.

The second insulating layer 25 may be disposed on the first insulating layer 23. The second insulating layer 25 may be disposed between the first insulating layer 23 and the third insulating layer 27. The second insulating layer 25 may cover the first insulating layer 23, the first electrode 31 and the first wiring 38. The first wiring 38 and the first section 31R1 of the first electrode 31 may be disposed between the first insulating layer 23 and the second insulating layer 25. The second section 31R2 of the first electrode 31 may be overlapped by the second insulating layer 25. In an embodiment, another insulating layer and/or another wiring is additionally disposed between the first insulating layer 23 and the second insulating layer 25, but they are omitted here for the sake of simplicity in description.

The second wiring 45 may be disposed on the second insulating layer 25. The second wiring 45 may include a third barrier layer 45B, a third seed layer 45S on the third barrier layer 45B, and a third conductive layer 45C on the third seed layer 45S. In an embodiment, a surface of the second wiring 45 contacts a surface of the second insulating layer 25. The lower surface of the third barrier layer 45B may contact the upper surface of the second insulating layer 25.

The third insulating layer 27 may cover the second wiring 45 and the second insulating layer 25. The upper surface of the third insulating layer 27 may form the second surface 21S2 of the wiring structure 21.

The second electrode 51 and the third electrode 53 may be disposed on the second surface 21S2 of the wiring structure 21. Each of the second electrode 51 and the third electrode 53 may penetrate the third insulating layer 27 and be connected to the second wiring 45. Each of the second electrode 51 and the third electrode 53 may partially extend along the upper surface of the third insulating layer 27. The second electrode 51 and the third electrode 53 may include fourth barrier layers 51B and 51B', fourth seed layers 51S and 51S' on the fourth barrier layers 51B and 51B', and fourth conductive layers 51C and 51C' on the fourth seed layers 51S and 51S', respectively. In an embodiment, surfaces of the second electrode 51 and the third electrode 53 contact surfaces of the second wiring 45. For example, the lower surfaces of the fourth barrier layers 51B and 51B' may contact upper surfaces of the third conductive layer 45C.

The second electrode 51 may be disposed in the flat area 21S2N of the second surface 21S2 of the wiring structure 21. The third electrode 53 may be disposed in the recessed area 21S2R of the second surface 21S2 of the wiring structure 21. The upper surfaces of the second electrode 51 and the third electrode 53 may be disposed at different levels. In an embodiment, the upper surface of the third electrode 53 is disposed at a lower level than the upper surface of the second electrode 51.

Referring to FIG. 3, the semiconductor package according to an embodiment of the present disclosure includes the wiring structure 21, the second electrode 51, the third electrode 53, the first bump 63, the second bump 73, the third bump 83, the first semiconductor chip 91, a second semiconductor chip 92, the underfill 95, and the first encapsulant 96. Configurations already described above with reference to FIG. 1 and FIG. 2 are not repeated here.

Referring to FIG. 3 together with FIG. 1 and FIG. 2, the first semiconductor chip 91 and the second semiconductor chip 92 may be disposed over the second surface 21S2 of the wiring structure 21. The underfill 95 may be disposed between the first semiconductor chip 91 and the wiring structure 21 and between the second semiconductor chip 92 and the wiring structure 21. The second bump 73 and the third bump 83 are connected to the second electrode 51 and the third electrode 53, respectively. The underfill 95 surrounds the sidewall of the second bump 73 and the sidewall of the third bump 83.

The first encapsulant 96 may cover the wiring structure 21 and the underfill 95 and may cover the side surfaces of the first semiconductor chip 91 and the second semiconductor chip 92. When the underfill 95 is omitted, the first encapsulant 96 may extend between the first semiconductor chip 91 and the wiring structure 21 and between the second semiconductor chip 92 and the wiring structure 21.

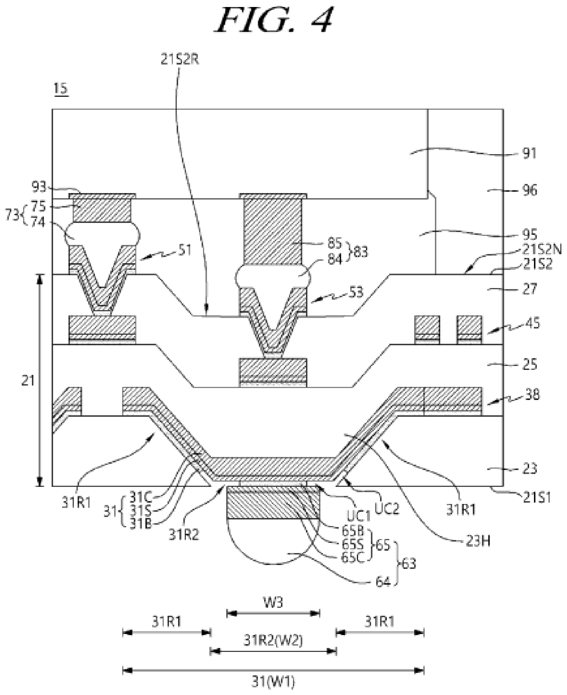

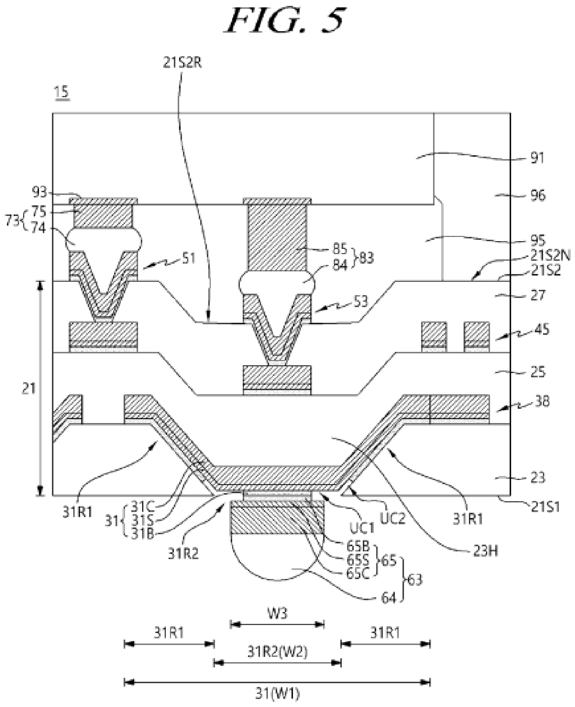

FIG. 4 and FIG. 5 are cross-sectional views of semiconductor packages according to some embodiments of the present disclosure. In different embodiments, FIG. 4 and FIG. 5 are partial views illustrating an part 15 of FIG. 3.

Referring to FIG. 4, the first barrier layer 31B in the first electrode 31 may be partially removed. In an embodiment, the second section 31R2 of the first electrode 31 includes the first seed layer 31S and the first conductive layer 31C. The first barrier layer 31B may be removed in the second section 31R2 of the first electrode 31. The second barrier layer 65B of the first conductive pillar 65 may contact the first seed layer 31S of the second section 31R2 of the first electrode 31. The second barrier layer 65B may be partially removed. The horizontal width of the second barrier layer 65B may be less than the horizontal width of the second seed layer 65S or the second conductive layer 65C. A first undercut area UC1 may be formed between the first seed layer 31S and the second seed layer 65S.

In an embodiment, the first barrier layer 31B is partially removed in the first section 31R1 of the first electrode 31. A second undercut area UC2 may be formed between the first insulating layer 23 and the first seed layer 31S of the first section 31R1 of the first electrode 31.

Referring to FIG. 5, the first barrier layer 31B may be partially removed in the second section 31R2 of the first electrode 31. The second barrier layer 65B of the first conductive pillar 65 may contact the first barrier layer 31B of the second section 31R2 of the first electrode 31. The second barrier layer 65B of the first conductive pillar 65 may be partially removed. A first undercut area UC1 may be formed between the first seed layer 31S of the second section 31R2 of the first electrode 31 and the second seed layer 65S of the first conductive pillar 65. A second undercut area UC2 may be formed between the first insulating layer 23 and the first seed layer 31S of the first section 31R1 of the first electrode 31.

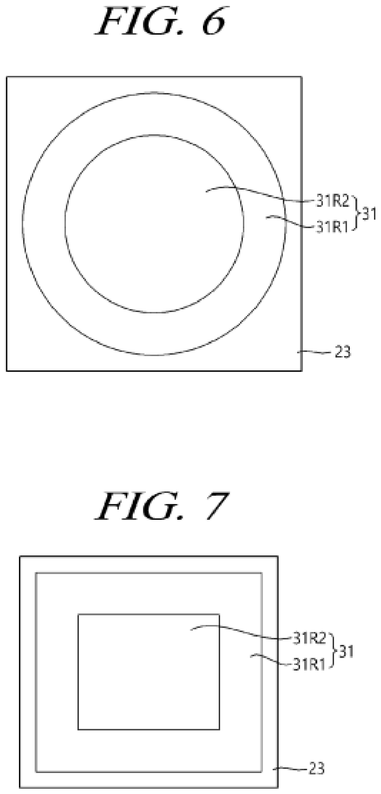

FIG. 6 to FIG. 10 are plan views of semiconductor packages according to some embodiments of the present disclosure.

Referring to FIG. 6, a first electrode 31 may have a circular shape. The first electrode 31 may include a first section 31R1 and a second section 31R2. The first section 31R1 may have a ring shape that surrounds the outer side of the second section 31R2. The second section 31R2 may have a circular shape that is delimited inside or bounded by the surrounding first section 31R1.

Referring to FIG. 7, a first electrode 31 may have a quadrangular shape. A first section 31R1 may have a quadrangular ring shape that surrounds the outer side of a second section 31R2. The second section 31R2 may have a quadrangular shape that is delimited inside or bounded by the surrounding first section 31R1.

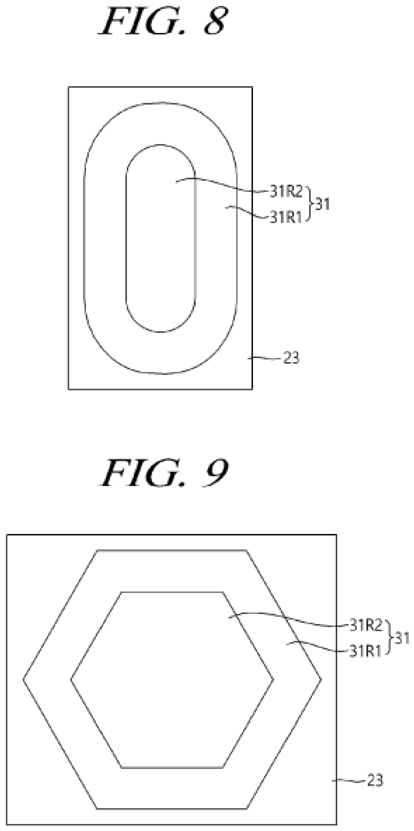

Referring to FIG. 8, a first electrode 31 may have an elliptical shape, a stadium shape, a capsule shape, or a discorectangle. A second section 31R2 may be delimited inside or bounded by a surrounding a first section 31R1. The first section 31R1 may surround the second section 31R2 with a constant width.

Referring to FIG. 9, a first electrode 31 may have a hexagonal shape. A first section 31R1 may have a hexagonal ring shape that surrounds the outer side of a second section 31R2. The second section 31R2 may have a hexagonal shape that is delimited inside or bounded by the surrounding first section 31R1.

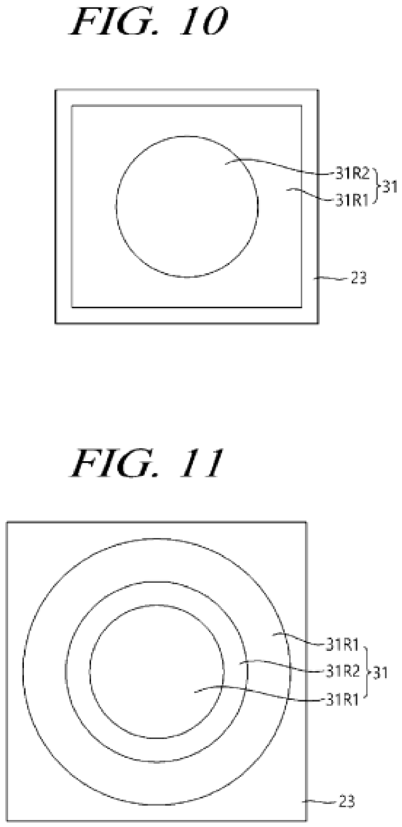

Referring to FIG. 10, a first electrode 31 may have a quadrangular shape. The outer surface of a first section 31R1 may have a quadrangular shape. The inner surface of the first section 31R1 may have a circular shape. A second section 31R2 may have a circular shape that is delimited inside or bounded by the surrounding first section 31R1.

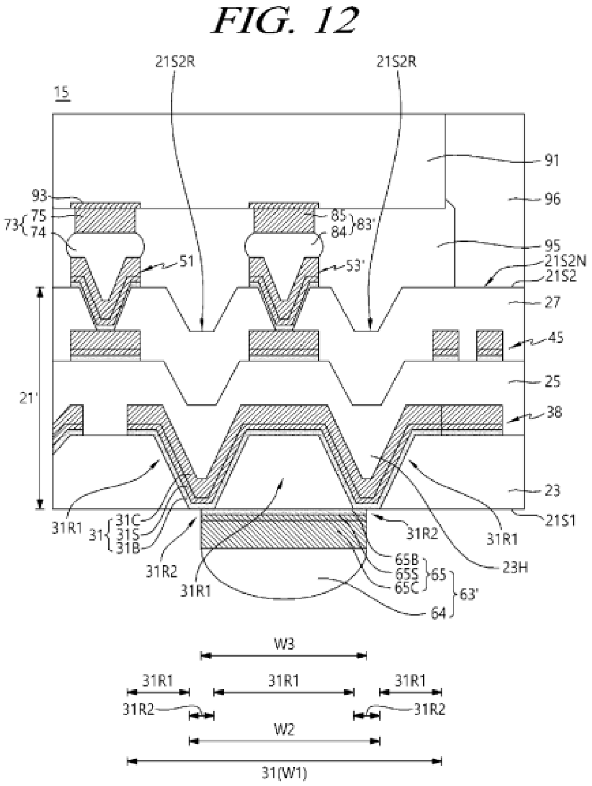

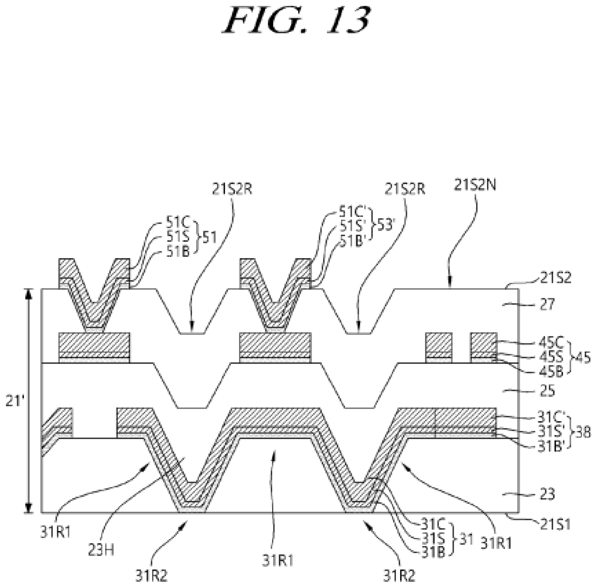

FIG. 11 is a plan view of a semiconductor package according to an embodiment of the present disclosure, and FIG. 12 is a cross-sectional view of the semiconductor package according to an embodiment of the present disclosure. FIG. 13 is a partial view illustrating a partial configuration (a wiring structure 21') of FIG. 12.

Referring to FIG. 11, a first electrode 31 may have a circular shape. A second section 31R2 of the first electrode 31 may have a ring shape that is delimited in or bounded by a first section 31R1 of the first electrode 31. The first section 31R1 of the first electrode 31 may have a ring shape that surrounds the outer side of the second section 31R2 of the first electrode 31 and a circular shape bounded within an inner side the second section 31R2 of the first electrode 31.

Referring to FIG. 12, a semiconductor package according to an embodiment of the present disclosure includes a wiring structure 21', a first bump 63', a second bump 73, a third bump 83', a first semiconductor chip 91, an underfill 95, and a first encapsulant 96. The wiring structure 21' may include a first surface 21S1 and a second surface 21S2. The first surface 21S1 of wiring structure 21' may form a flat surface. The second surface 21S2 of wiring structure 21' may include a flat area 21S2N and a recessed area 21S2R. The wiring structure 21' is described in detail with reference to FIG. 13.

The first bump 63' may be disposed on the first surface 21S1 of the wiring structure 21'. The first bump 63' may contact a surface of the first electrode 31. In an embodiment, the first bump 63' contacts the lower surface of the second section 31R2 of the first electrode 31. The horizontal width of the first electrode 31 is a first width W1, indicated in FIG. 12 as 31(W1). The outer diameter of the second section 31R2 of the first electrode 31 has a second width W2. The second width W2 may be less than the first width W1. The horizontal width of a first conductive pillar 65 is a third width W3. The third width W3 may be less than the first width W1. In an embodiment, the third width W3 is less than the second width W2.

The first bump 63' may be overlapped by the second section 31R2 of the first electrode 31. The first bump 63' may also be overlapped by a first insulating layer 23 on the first section 31R1 of the first electrode 31 that is bounded inside of the second section 31R2 of the first electrode 31 having a ring shape. In an embodiment, the first conductive pillar 65 is overlapped by the second section 31R2 of the first electrode 31. The first conductive pillar 65 may also be overlapped by the first insulating layer 23 in the first section 31R1 of the first electrode 31 that is delimited inside of the second section 31R2 of the first electrode 31 having a ring shape.

A second electrode 51 and a third electrode 53' may be disposed on the second surface 21S2 of wiring structure 21'. The second electrode 51 and the third electrode 53' may be disposed in the flat area 21S2N. The second bump 73 may be disposed between the first semiconductor chip 91 and the wiring structure 21'. The second bump 73 may be connected to the first semiconductor chip 91 and the second electrode 51. The third bump 83' may be disposed between the first semiconductor chip 91 and the wiring structure 21'. The third bump 83' may be connected to the first semiconductor chip 91 and the third electrode 53'. The underfill surrounds the second bump 73 and the third bump 83'. The height of the third bump 83' may be substantially the same as the height of the second bump 73. In an embodiment, the height of a third conductive pillar 85 is substantially the same as the height of a second conductive pillar 75.

Referring to FIG. 13, the wiring structure 21' may include the first insulating layer 23, a second insulating layer 25, a third insulating layer 27, the first electrode 31, a first wiring 38, and a second wiring 45. The wiring structure 21' may include the first surface 21S1 and the second surface 21S2 that faces away from the first surface 21S1. The second surface 21S2 of wiring structure 21' may include the flat area 21S2N and the recessed area 21S2R. The recessed area 21S2R of the second surface 21S2 of wiring structure 21' may overlap the second section 31R2 of the first electrode 31.

The first electrode 31 may penetrate the first insulating layer 23. The first electrode 31 may include the first section 31R1 that overlaps the first insulating layer 23 and the second section 31R2 that does not overlap the first insulating layer 23. As illustrated in FIG. 11, the second section 31R2 of the first electrode 31 may have a ring shape that is delimited in the first electrode 31. The first section 31R1 of the first electrode 31 may extend along an inclined surface of the first insulating layer 23 in a first opening 23H from the upper surface of the first insulating layer 23. The second section 31R2 of the first electrode 31 may be disposed at the bottom of the first opening 23H.

The second electrode 51 and the third electrode 53' may be disposed on the second surface 21S2 of the wiring structure 21'. The second electrode 51 and the third electrode 53' may be disposed in the flat area 21S2N. The upper surfaces of the second electrode 51 and the third electrode 53' may be disposed at substantially the same level.

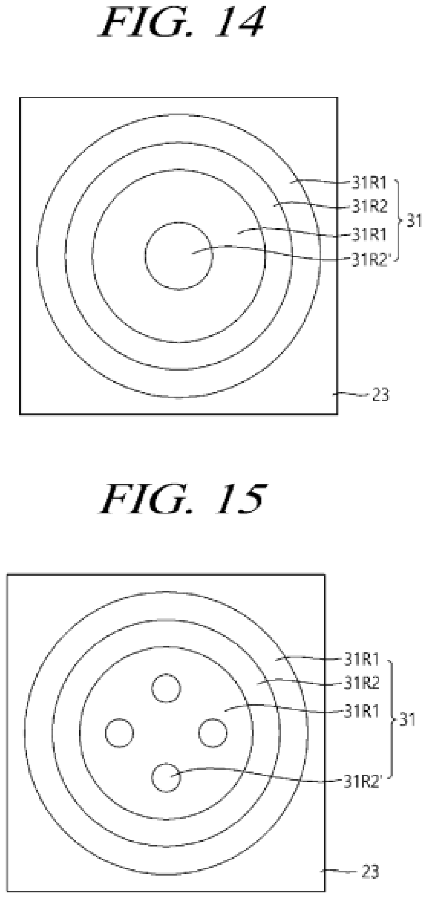

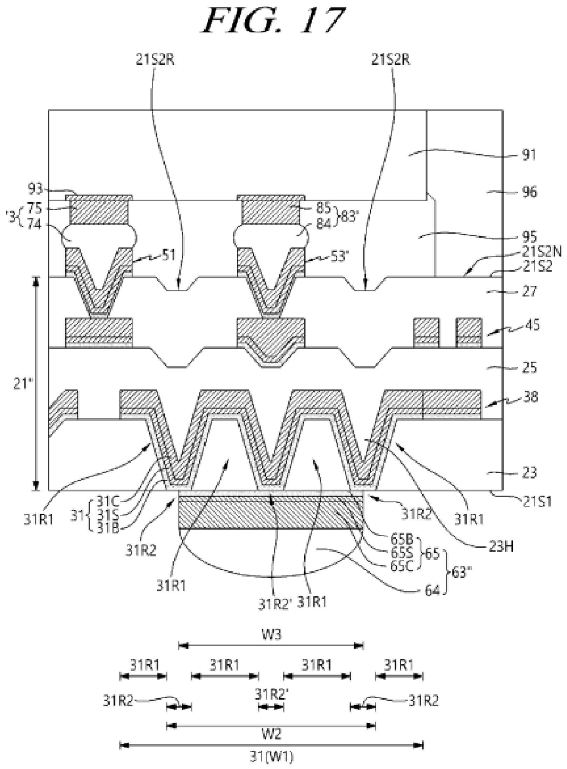

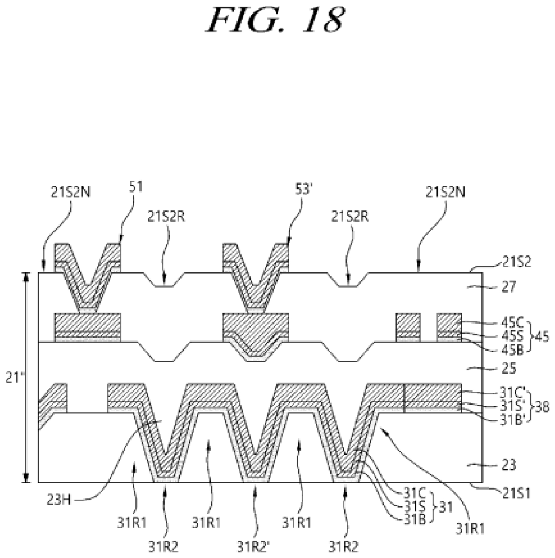

FIG. 14 to FIG. 16 are plan views of semiconductor packages according to some embodiments of the present disclosure, and FIG. 17 is a cross-sectional view of a semiconductor package according to an embodiment of the present disclosure. FIG. 18 is a partial view illustrating a partial configuration (a wiring structure 21") of FIG. 17.

Referring to FIG. 14, a first electrode 31 may have a circular shape. Second sections 31R2 and 31R2' of the first electrode 31 may be delimited or bounded in the first electrode 31. The second sections 31R2 and 31R2' may include an outer second section 31R2 and an inner second section 31R2'. The inner second section 31R2' may be within the outer second section 31R2. The outer second section 31R2 may have a ring or annulus shape. The inner second section 31R2' may have a circular shape. A first section 31R1 may have a ring shape that surrounds the outer side of the outer second section 31R2 and a ring shape that is bounded between the inner second section 31R2' and the outer second section 31R2.

Referring to FIG. 15, second sections 31R2 and 31R2' of the first electrode 31 may include an outer second section 31R2 and a plurality of inner second sections 31R2'. The plurality of inner second sections 31R2' may be within in the outer second section 31R2. The outer second section 31R2 may have a ring or annulus shape. Each of the plurality of inner second sections 31R2' may have a circular shape. A first section 31R1 may have a ring or annulus shape that surrounds the outer side of the outer second section 31R2, and the first section 31R1 may be bounded between the inner side of the outer second section 31R2 and the plurality of inner second sections 31R2'.

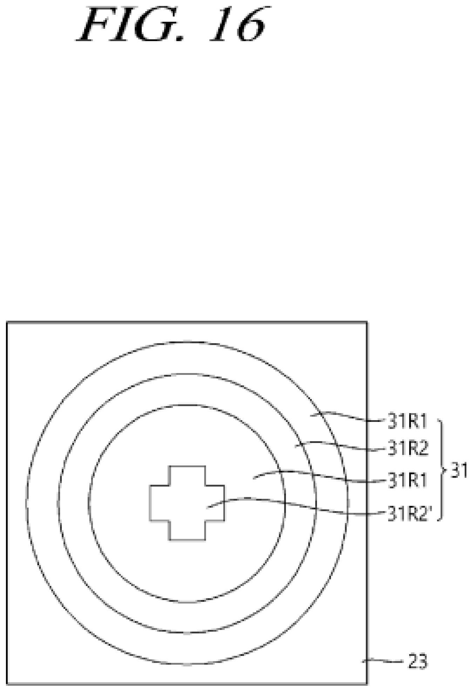

Referring to FIG. 16, second sections 31R2 and 31R2' of the first electrode 31 may include an outer second section 31R2 and an inner second section 31R2'. The inner second section 31R2' may be within in the outer second section 31R2. The outer second section 31R2 may have a ring or annulus shape. The inner second section 31R2' may have a cross shape. A first section 31R1 may have a ring or annulus shape that surrounds the outer side of the outer second section 31R2, and the first section 31R1 may be bounded between the inner side of the outer second section 31R2 and the inner second section 31R2'.

Referring to FIG. 17, a semiconductor package according to an embodiment of the present disclosure includes a wiring structure 21", a first bump 63", a second bump 73, a third bump 83', a first semiconductor chip 91, an underfill 95, and a first encapsulant 96. The wiring structure 21" may include a first surface 21S1 and a second surface 21S2. The second surface 21S2 of wiring structure 21" may include a flat area 21S2N and a recessed area 21S2R. The wiring structure 21" is described in detail with reference to FIG. 18.

The first bump 63" may be disposed on the first surface 21S1 of the wiring structure 21". The first bump 63" may contact a surface of the first electrode 31. In an embodiment, the first bump 63" contacts the lower surfaces of the second sections 31R2 and 31R2' of the first electrode 31. The horizontal width of the first electrode 31 is a first width W1. The outer diameter of the second sections 31R2 and 31R2' of the first electrode 31 has a second width W2. The second width W2 may be less than the first width W1. The horizontal width of a first conductive pillar 65 is a third width W3. The third width W3 may be less than the first width W1. In an embodiment, the third width W3 is less than the second width W2.

The first bump 63" may be overlapped by the entirety of the inner second section 31R2' of the first electrode 31 and a portion of the outer second section 31R2 of the first electrode 31. The first bump 63" may be overlapped by a portion of first insulating layer 23 under the first section 31R1 of the first electrode 31 that is delimited between the outer second section 31R2 of the first electrode 31 and the inner second section 31R2' of the first electrode 31. In an embodiment, the first conductive pillar 65 is overlapped by the entirety of the inner second section 31R2' of the first electrode 31 and a portion of the outer second section 31R2 of the first electrode 31. The first conductive pillar 65 may be overlapped by the portion of the first insulating layer 23 under the first section 31R1 of the first electrode 31 that is delimited between the outer second section 31R2 of the first electrode 31 and the inner second section 31R2' of the first electrode 31.

A second electrode 51 and a third electrode 53' may be disposed on the second surface 21S2 of the wiring structure 21". The second electrode 51 and the third electrode 53' may be disposed in the flat area 21S2N of the second surface 21S2 of wiring structure 21". The second bump 73 may be disposed between the first semiconductor chip 91 and the wiring structure 21". The second bump 73 may be connected to the first semiconductor chip 91 and the second electrode 51. The third bump 83' may be disposed between the first semiconductor chip 91 and the wiring structure 21". The third bump 83' may be connected to the first semiconductor chip 91 and the third electrode 53'. The underfill 95 surround sidewall of the second bump 73 and sidewall of the third bump 83'. The height of the third bump 83' may be substantially the same as the height of the second bump 73. In an embodiment, the height of a third conductive pillar 85 is substantially the same as the height of a second conductive pillar 75.

Referring to FIG. 18, the wiring structure 21" may include the first insulating layer 23, a second insulating layer 25, a third insulating layer 27, the first electrode 31, a first wiring 38, and a second wiring 45. The wiring structure 21" may include the first surface 21S1 and the second surface 21S2 that faces away from the first surface 21S1. The second surface 21S2 of wiring structure 21" may include the flat area 21S2N and the recessed area 21S2R.

The first electrode 31 may penetrate the first insulating layer 23. The first electrode 31 may include the first section 31R1 that overlaps the first insulating layer 23 and the second sections 31R2 and 31R2' that do not overlap the first insulating layer 23. As illustrated in FIG. 14, the second sections 31R2 and 31R2' may be delimited in the first electrode 31. The second sections 31R2 and 31R2' may include the outer second section 31R2 and the inner second section 31R2'. The inner second section 31R2' may be delimited by the outer second section 31R2. The outer second section 31R2 may have a ring shape. The first section 31R1 may have a ring shape that surrounds the outer side of the outer second section 31R2 and a ring shape that is delimited between the inner second section 31R2' and the outer second section 31R2.

The second electrode 51 and the third electrode 53' may be disposed on the second surface 21S2 of the wiring structure 21". The recessed area 21S2R of the second surface 21S2 of wiring structure 21" may overlap the second sections 31R2 and 31R2' of the first electrode 31. The second electrode 51 and the third electrode 53' may be disposed in the flat area 21S2N of the second surface 21S2 of wiring structure 21". The upper surfaces of the second electrode 51 and the third electrode 53' may be disposed at substantially the same level.

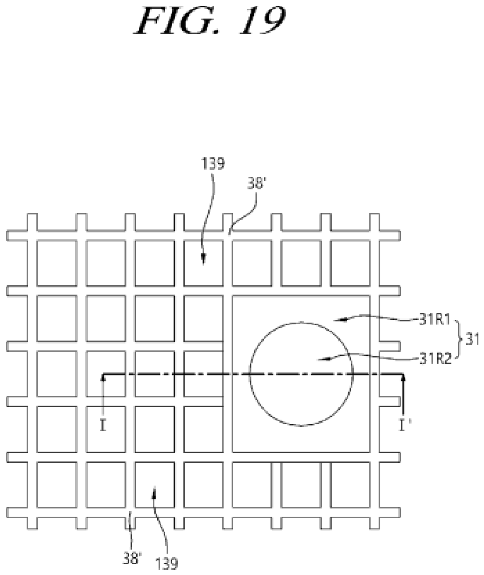

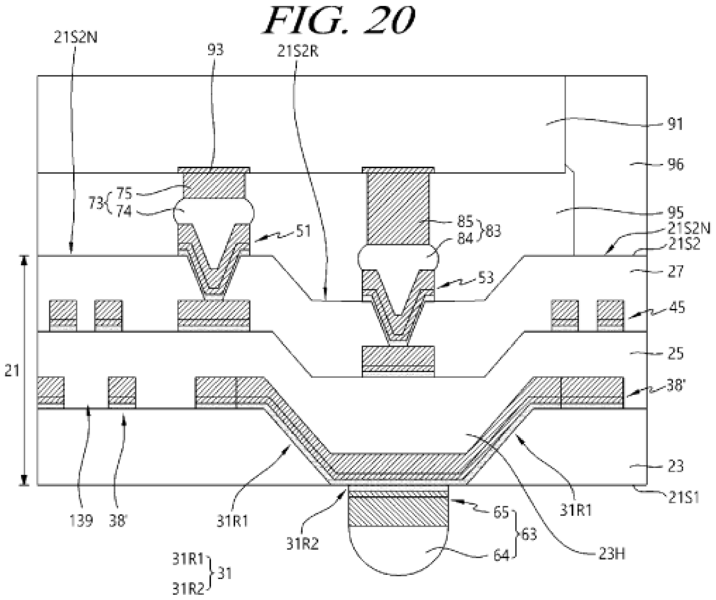

FIG. 19 is a plan view of a semiconductor package according to an embodiment of the present disclosure, and FIG. 20 is a cross-sectional view of a semiconductor package according to an embodiment of the present disclosure. In an embodiment, FIG. 20 is a cross-sectional view taken along a section line I-I' of FIG. 19.

Referring to FIG. 19, a semiconductor package according to an embodiment of the present disclosure includes a first electrode 31, a first wiring 38', and a degassing hole 139. The first electrode 31 may include a first section 31R1 and a second section 31R2. The second section 31R2 may be delimited inside the first section 31R1. The first section 31R1 may surround the second section 31R2. The first wiring 38' may be continuous to the first section 31R1 of the first electrode 31. The degassing hole 139 may penetrate the first wiring 38'. The first wiring 38' may have a mesh shape or a lattice shape. In an embodiment, the first wiring 38' includes a ground wiring.

Referring to FIG. 20, the first wiring 38' may be disposed between a first insulating layer 23 and a second insulating layer 25. The first wiring 38' may contact the side surface of the first section 31R1 of the first electrode 31. The degassing hole 139 may penetrate the first wiring 38'. The interior of the degassing hole 139 may be filled with the second insulating layer 25. The degassing hole 139 may provide a path through which gas generated inside a wiring structure 21 is discharged.

Referring again to FIG. 1 to FIG. 20, the first electrode 31, the first section 31R1 and the second section 31R2 may include various shapes, such as a circular shape, a quadrangular shape, a polygonal shape, or a combination thereof.

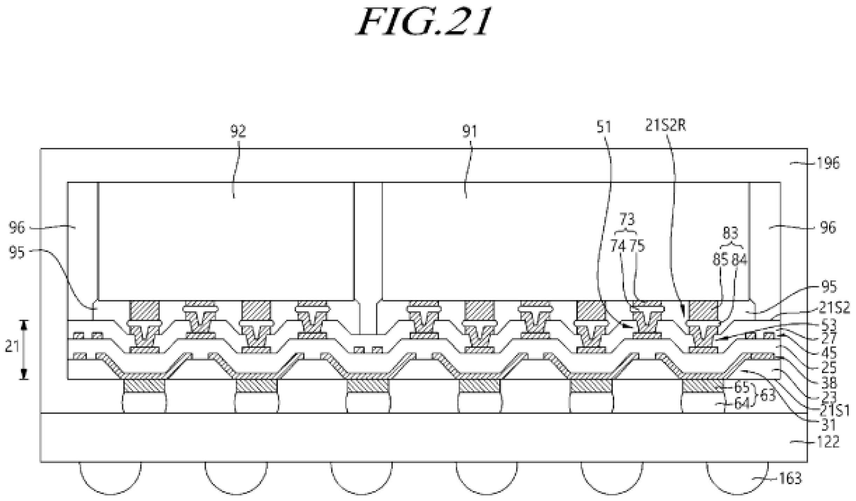

FIG. 21 is a cross-sectional view of a semiconductor package according to an embodiment of the present disclosure.

Referring to FIG. 21, a semiconductor package according to an embodiment of the present disclosure includes a wiring structure 21, a second electrode 51, a third electrode 53, a first bump 63, a second bump 73, a third bump 83, a first semiconductor chip 91, a second semiconductor chip 92, an underfill 95, a first encapsulant 96, a package substrate 122, an external terminal 163, and a second encapsulant 196. Because the wiring structure 21, the second electrode 51, the third electrode 53, the first bump 63, the second bump 73, the third bump 83, the first semiconductor chip 91, the second semiconductor chip 92, the underfill 95, and the first encapsulant 96 have been described above with reference to FIG. 1 to FIG. 20, repetitive descriptions are omitted here.

Each of the first semiconductor chip 91 and the second semiconductor chip 92 may include volatile memory, nonvolatile memory, a controller, an application processor, a microprocessor, or a combination thereof. Each of the first semiconductor chip 91 and the second semiconductor chip 92 may include dynamic random-access memory (DRAM), static random-access memory (SRAM), flash memory, magnetoresistive random-access memory (MRAM), phase-change random-access memory (PRAM), ferroelectric random-access memory (FRAM), resistive random-access memory (RRAM), or a combination thereof.

The package substrate 122 may include a printed circuit board, an interposer, a base chip, a communication chip, or a combination thereof. The first bump 63 may be mounted on the package substrate 122. The external terminal 163 may include a solder ball, a conductive bump, a conductive pin, or a combination thereof. The external terminal 163 may be disposed on the lower surface of the package substrate 122.

The first encapsulant 96 and the second encapsulant 196 may include an epoxy molding compound. The second encapsulant 196 may cover the package substrate 122 and may cover the wiring structure 21, the first semiconductor chip 91, the second semiconductor chip 92, and the first encapsulant 96. The second encapsulant 196 may extend between the wiring structure 21 and the package substrate 122.

A semiconductor package according to an embodiment of the present disclosure includes a first conductive pillar 65 that has a narrower width than a second section 31R2 (see FIG. 1) of a first electrode 31. In an embodiment, the first conductive pillar 65 is overlapped by a second section 31R2 of the first electrode 31. The first conductive pillar 65 does not overlap a first insulating layer 23. For some embodiments, the stress between the first bump 63 and the first insulating layer 23 is reduced. Further, the reliability of a semiconductor package may be improved.

FIG. 22 to FIG. 34 are cross-sectional views for describing a method of forming a semiconductor package according to an embodiment of the present disclosure. A method of forming a semiconductor package according to an embodiment of the present disclosure includes a semi-additive process (SAP).

Referring to FIG. 22, a first buffer layer 212 may be formed on a first carrier 211. A first insulating layer 23 may be formed on the first buffer layer 212. A first opening 23H that penetrates the first insulating layer 23 may be formed. The first buffer layer 212 may be exposed at the bottom of the first opening 23H. The side surface of the first insulating layer 23 may be exposed in the first opening 23H. In a cross-sectional view, the first opening 23H may include various profiles, such as an inverted trapezoid in which the upper width of the first opening 23H is greater than the lower width of the first opening 23H, a trapezoid in which the upper width of the first opening 23H is less than the lower width of the first opening 23H, a quadrangle in which the upper width of the first opening 23H and the lower width of the first opening 23H are substantially the same, or a combination thereof. However, for the sake of simplicity, the following description is made under the assumption that the first opening 23H has the shape of an inverted trapezoid in which the upper width of the first opening 23H is greater than the lower width of the first opening 23H. The sidewall of the first insulating layer 23 that is exposed in the first opening 23H may include an inclined shape.

The first insulating layer 23 may include a single layer or a multilayer. The first insulating layer 23 may include at least two of silicon (Si), oxygen (O), nitrogen (N), carbon (C), and boron (B). The first insulating layer 23 may include silicon oxide, silicon nitride, silicon oxynitride, silicon carbon nitride (SiCN), silicon oxycarbon nitride (SiOCN), low-k dielectric, high-k dielectric, or a combination thereof. In an embodiment, the first insulating layer 23 includes polyimide (PI), polybenzoxazole (PBO), benzocyclobutene (BCB), polyhydroxystyrene (PHS), or a combination thereof. Forming the first opening 23H that penetrates the first insulating layer 23 may include a patterning process.

Referring to FIG. 23, a first barrier layer 31B and a first seed layer 31S may be sequentially formed on the first insulating layer 23 that has the first opening 23H. As illustrated in FIG. 1 and FIG. 2, the first seed layer 31S may be formed on the first barrier layer 31B.

In an embodiment, the first barrier layer 31B covers the upper surface and side surface of the first insulating layer 23 and cover the first buffer layer 212 in the first opening 23H. The first seed layer 31S may cover the first barrier layer 31B. The first barrier layer 31B may include a single layer or a multilayer. The first barrier layer 31B may include titanium (Ti), titanium nitride (TiN), tantalum (Ta), tantalum nitride (TaN), or a combination thereof. The first seed layer 31S may include a single layer or a multilayer. The first seed layer 31S may include a conductive material, such as copper.

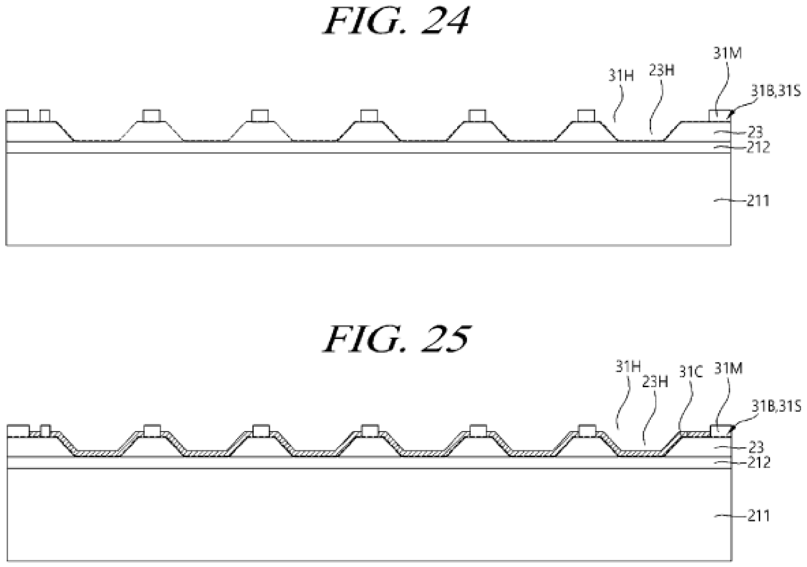

Referring to FIG. 24, a first mask pattern 31M that has a second opening 31H may be formed on the first seed layer 31S. The first mask pattern 31M may include a photoresist pattern, a hard mask pattern, or a combination thereof. The first seed layer 31S may be exposed at the bottom of the second opening 31H. In an embodiment, the second opening 31H overlaps the first opening 23H. The horizontal width of the second opening 31H may be greater than the horizontal width of the first opening 23H.

Referring to FIG. 25, a first conductive layer 31C may be formed on the first seed layer 31S in the second opening 31H. The first conductive layer 31C may include metal, metal nitride, conductive carbon, or a combination thereof. The first conductive layer 31C may include copper (Cu), tungsten (W), tungsten nitride (WN), Ti, TiN, Ta, TaN, cobalt (Co), nickel (Ni), silver (Ag), platinum (Pt), ruthenium (Ru), gold (Au), aluminum (Al), tin (Sn), or a combination thereof. In an embodiment, the first conductive layer 31C includes copper by an electrolytic plating method.

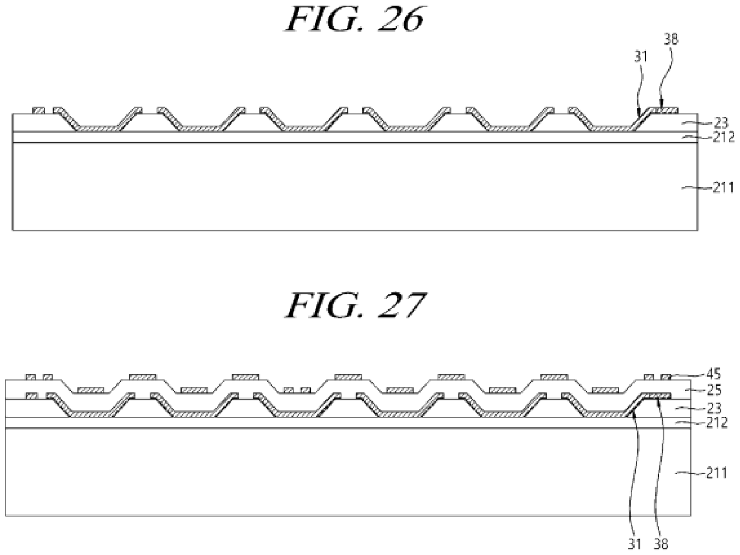

Referring to FIG. 26, the first mask pattern 31M may be removed. The first seed layer 31S and the first barrier layer 31B may be partially removed. As illustrated in FIG. 1 and FIG. 2, the first seed layer 31S and the first barrier layer 31B may be preserved under the first conductive layer 31C. The first barrier layer 31B, the first seed layer 31S, and the first conductive layer 31C may constitute a first electrode 31 and a first wiring 38. In an embodiment, the first electrode 31 is formed in the first opening 23H (see FIG. 25) and extend onto the first insulating layer 23. The first wiring 38 may be formed on the first insulating layer 23 and may contact the side surface of the first electrode 31.

Referring to FIG. 27, a second insulating layer 25 that covers the first electrode 31, the first wiring 38, and the first insulating layer 23 may be formed. A second wiring 45 may be formed on the second insulating layer 25. As illustrated in FIG. 1 and FIG. 2, the second wiring 45 may include a third barrier layer 45B, a third seed layer 45S, and a third conductive layer 45C that are sequentially stacked.

The second insulating layer 25 may include a single layer or a multilayer. The second insulating layer 25 may include at least two of Si, O, N, C, and B. The second insulating layer 25 may include silicon oxide, silicon nitride, silicon oxynitride, silicon carbon nitride (SiCN), silicon oxycarbon nitride (SiOCN), low-k dielectric, high-k dielectric, or a combination thereof. In an embodiment, the second insulating layer 25 includes polyimide (PI), polybenzoxazole (PBO), benzocyclobutene (BCB), polyhydroxystyrene (PHS), or a combination thereof.

The third barrier layer 45B may include a single layer or a multilayer. The third barrier layer 45B may include Ti, TiN, Ta, TaN, or a combination thereof. The third seed layer 45S may include a single layer or a multilayer. The third seed layer 45S may include a conductive material, such as copper. The third conductive layer 45C may include metal, metal nitride, conductive carbon, or a combination thereof. The third conductive layer 45C may include Cu, W, WN, Ti, TiN, Ta, TaN, Co, Ni, Ag, Pt, Ru, Au, Al, Sn, or a combination thereof. In an embodiment, the third conductive layer 45C includes copper by an electrolytic plating method.

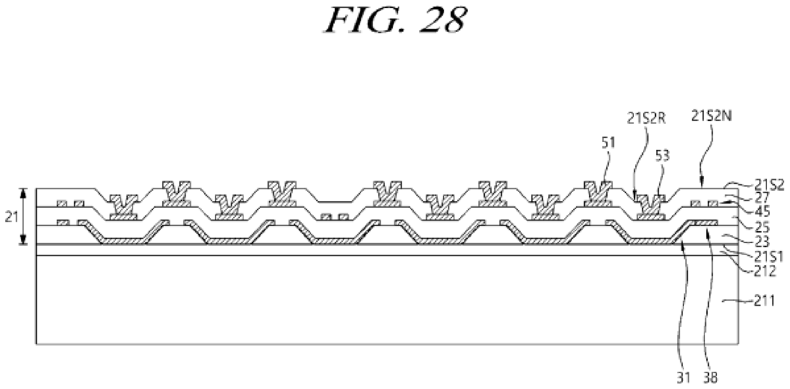

Referring to FIG. 28, a third insulating layer 27 that covers the second wiring 45 and the second insulating layer 25 may be formed. A second electrode 51 and a third electrode 53 that are connected to the second wiring 45 through the third insulating layer 27 may be formed. As illustrated in FIG. 1 and FIG. 2, each of the second electrode 51 and the third electrode 53 may include a fourth barrier layer 51B, a fourth seed layer 51S, and a fourth conductive layer 51C that are sequentially stacked. The first insulating layer 23, the second insulating layer 25, the third insulating layer 27, the first electrode 31, the first wiring 38, and the second wiring 45 may constitute a wiring structure 21. The wiring structure 21 may include a first surface 21S1 and a second surface 21S2.

The third insulating layer 27 may include a single layer or a multilayer. The third insulating layer 27 may include at least two of Si, O, N, C and B. The third insulating layer 27 may include silicon oxide, silicon nitride, silicon oxynitride, silicon carbon nitride (SiCN), silicon oxycarbon nitride (SiOCN), low-k dielectric, high-k dielectric, or a combination thereof. In an embodiment, the third insulating layer 27 includes polyimide (PI), polybenzoxazole (PBO), benzocyclobutene (BCB), polyhydroxystyrene (PHS), or a combination thereof.

The fourth barrier layer 51B may include a single layer or a multilayer. The fourth barrier layer 51B may include Ti, TiN, Ta, TaN, or a combination thereof. The fourth seed layer 51S may include a single layer or a multilayer. The fourth seed layer 51S may include a conductive material, such as copper. The fourth conductive layer 51C may include metal, metal nitride, conductive carbon, or a combination thereof. The fourth conductive layer 51C may include Cu, W, WN, Ti, TiN, Ta, TaN, Co, Ni, Ag, Pt, Ru, Au, Al, Sn, or a combination thereof. In an embodiment, the fourth conductive layer 51C includes copper by an electrolytic plating method.

The lower surfaces of the first insulating layer 23 and the first electrode 31 may form the first surface 21S1 of the wiring structure 21. The shape of the first surface 21S1 of the wiring structure 21 may be determined depending on the first carrier 211 and/or the first buffer layer 212. In an embodiment, the first surface 21S1 of the wiring structure 21 is a flat surface.

The upper surface of the third insulating layer 27 may form the second surface 21S2 of the wiring structure 21. The second surface 21S2 of the wiring structure 21 may face away from the first surface 21S1 of the wiring structure 21. The shape of the second surface 21S2 of the wiring structure 21 may be determined depending on the first insulating layer 23 and the first electrode 31. In an embodiment, the second surface 21S2 of the wiring structure 21 includes a flat area 21S2N and a recessed area 21S2R. The recessed area 21S2R may overlap the first electrode 31. In an embodiment, the second electrode 51 is formed in the flat area 21S2N, and the third electrode 53 may be formed in the recessed area 21S2R.

In an embodiment, the wiring structure 21 is formed to have various configurations and shapes, as described above with reference to FIG. 1 to FIG. 20.

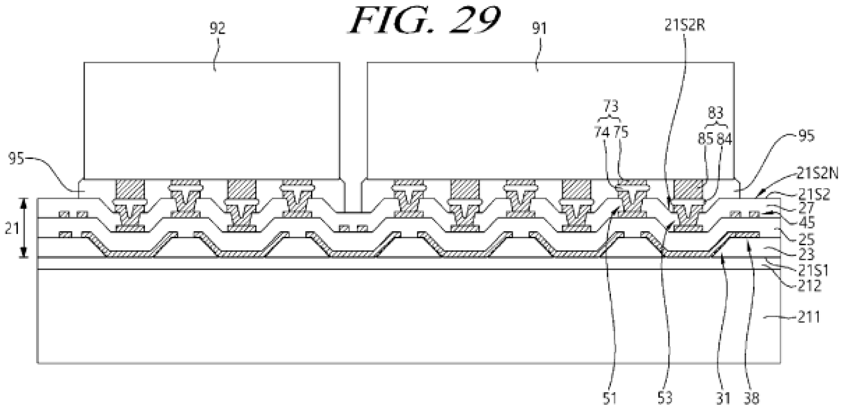

Referring to FIG. 29, a first semiconductor chip 91 and a second semiconductor chip 92 may be placed on the second surface 21S2 of the wiring structure 21. A second bump 73 and a third bump 83 may be formed between the first semiconductor chip 91 and the wiring structure 21 and between the second semiconductor chip 92 and the wiring structure 21. An underfill 95 may be formed between the first semiconductor chip 91 and the wiring structure 21 and between the second semiconductor chip 92 and the wiring structure 21. In an embodiment, the underfill 95 is omitted.

The second bump 73 may include a second solder layer 74 and a second conductive pillar 75. The third bump 83 may include a third solder layer 84 and a third conductive pillar 85. Each of the second solder layer 74 and the third solder layer 84 may include Sn, Ag, Cu, Bi, In, Zn, Au, Pd, Sb, or a combination thereof. Each of the second conductive pillar 75 and the third conductive pillar 85 may include a single layer or a multilayer. Each of the second conductive pillar 75 and the third conductive pillar 85 may include metal, metal nitride, conductive carbon, or a combination thereof. Each of the second conductive pillar 75 and the third conductive pillar 85 may include Cu, W, WN, Ti, TiN, Ta, TaN, Co, Ni, Ag, Pt, Ru, Au, Al, Sn, or a combination thereof. In an embodiment, each of the second conductive pillar 75 and the third conductive pillar 85 include copper by an electrolytic plating method.

In an embodiment, the second bump 73 is formed between the first semiconductor chip 91 and the second electrode 51. The second solder layer 74 may act as a contact between the second conductive pillar 75 and the second electrode 51. The third bump 83 may be formed between the first semiconductor chip 91 and the third electrode 53. The third solder layer 84 may act as a contact between the third conductive pillar 85 and the third electrode 53. The distance between the first semiconductor chip 91 and the third electrode 53 may be greater than the distance between the first semiconductor chip 91 and the second electrode 51. The height of the third conductive pillar 85 may be greater than the height of the second conductive pillar 75.

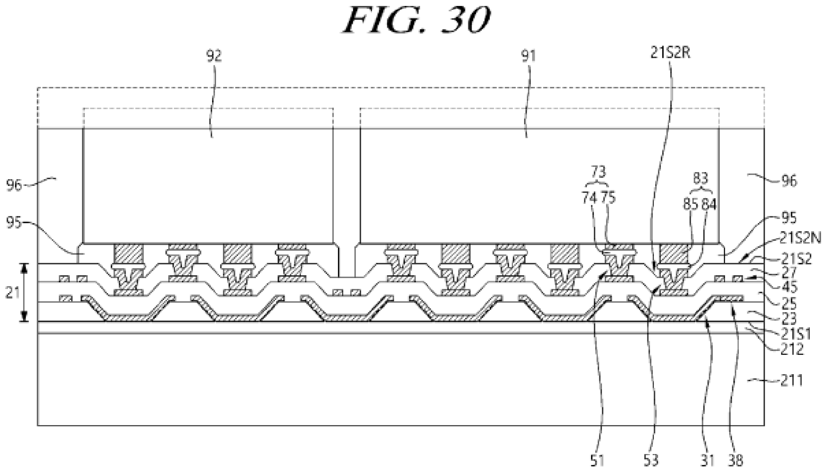

Referring to FIG. 30, a first encapsulant 96 that covers the first semiconductor chip 91, the second semiconductor chip 92, and the underfill 95 may be formed on the wiring structure 21. By partially removing the first encapsulant 96, the other surfaces of the first semiconductor chip 91 and the second semiconductor chip 92 may be exposed. The first encapsulant 96 may include an epoxy molding compound. When the underfill 95 is omitted, the first encapsulant 96 may extend between the first semiconductor chip 91 and the wiring structure 21 and between the second semiconductor chip 92 and the wiring structure 21.

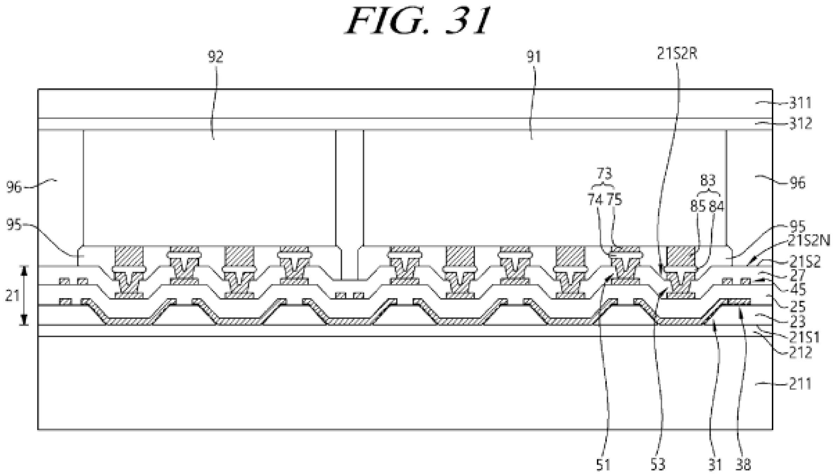

Referring to FIG. 31, a second buffer layer 312 and a second carrier 311 may be sequentially attached on the first semiconductor chip 91, the second semiconductor chip 92 and the first encapsulant 96.

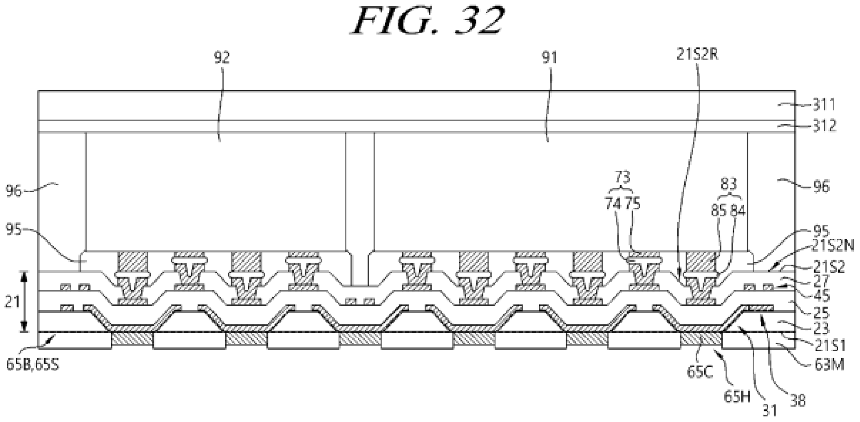

Referring to FIG. 32, by removing the first carrier 211 and the first buffer layer 212, the first surface 21S1 of the wiring structure 21 may be exposed. A second barrier layer 65B and a second seed layer 65S may be sequentially formed on the first surface 21S1 of the wiring structure 21. As illustrated in FIG. 1, the second barrier layer 65B may be formed between the second seed layer 65S and the first surface 21S1 of the wiring structure 21. In an embodiment, the second barrier layer 65B is formed to completely cover the first surface 21S1 of the wiring structure 21. The second seed layer 65S may be formed to cover the second barrier layer 65B.

A second mask pattern 63M that has a third opening 65H may be formed on the second seed layer 65S. The second seed layer 65S may be exposed in the third opening 65H. A second conductive layer 65C may be formed on the second seed layer 65S that is exposed in the third opening 65H.

The second barrier layer 65B may include a single layer or a multilayer. The second barrier layer 65B may include Ti, TiN, Ta, TaN, or a combination thereof. The second seed layer 65S may include a single layer or a multilayer. The second seed layer 65S may include a conductive material, such as copper. The second conductive layer 65C may include metal, metal nitride, conductive carbon, or a combination thereof. The second conductive layer 65C may include Cu, W, WN, Ti, TiN, Ta, TaN, Co, Ni, Ag, Pt, Ru, Au, Al, Sn, or a combination thereof. In an embodiment, the second conductive layer 65C includes copper by an electrolytic plating method.

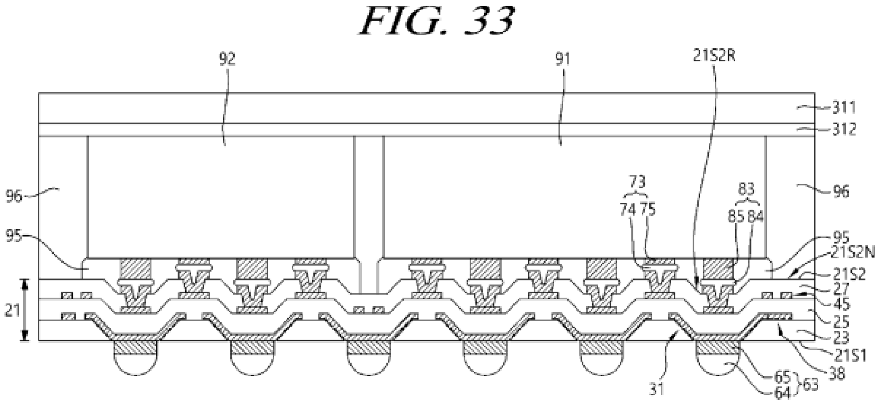

Referring to FIG. 33, the second mask pattern 63M may be completely removed, and the second barrier layer 65B and the second seed layer 65S may be partially removed. As illustrated in FIG. 1, the second barrier layer 65B and the second seed layer 65S may be preserved between the second conductive layer 65C and the first electrode 31. The second barrier layer 65B, the second seed layer 65S, and the second conductive layer 65C may constitute a first conductive pillar 65. A first solder layer 64 may be formed on the first conductive pillar 65. The first solder layer 64 and the first conductive pillar 65 may constitute a first bump 63. The first solder layer 64 may include Sn, Ag, Cu, Bi, In, Zn, Au, Pd, Sb, or a combination thereof.

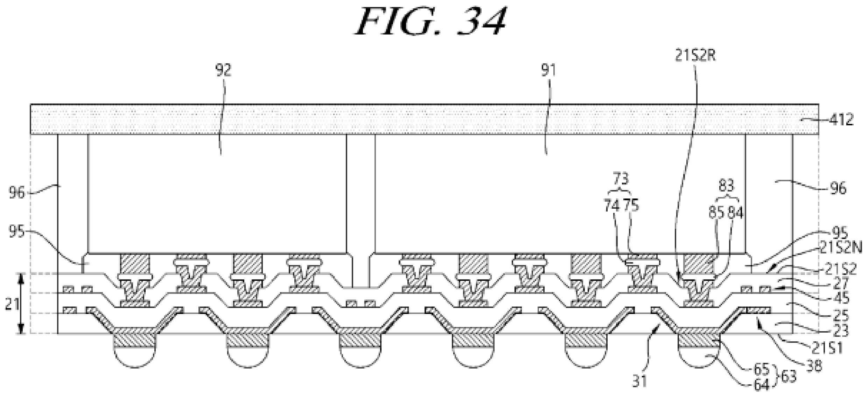

Referring to FIG. 34, the second carrier 311 and the second buffer layer 312 may be removed, and lamination tape 412 may be attached. Semiconductor packages may be divided using a singulation process.

While some embodiments are described in the present disclosure, those skilled in the art will understand that various modifications, additions, and/or substitutions related to these embodiments are possible without departing from the scope and technical concepts of the present disclosure. Therefore, the scope of the present disclosure should not be limited to the foregoing described embodiments. All changes within the meaning and range of equivalency of the claims are included within the scope of the present disclosure.

## Claims

1. A semiconductor package comprising:
a wiring structure including a first electrode and having a first surface and a second surface that faces away from the first surface;
a first bump including a first conductive pillar on the first surface of the wiring structure and a first solder layer on the first conductive pillar, wherein the first bump contacts the first electrode; and
a semiconductor chip over the second surface of the wiring structure,
wherein the second surface of the wiring structure includes a recessed area that overlaps the first electrode,
wherein the first electrode includes a first section and a second section, the first section of the first electrode is disposed between the first surface of the wiring structure and the second surface of the wiring structure, and the second section of the first electrode has a lower surface that is included in the first surface of the wiring structure, and
wherein the horizontal width of the first conductive pillar is less than the horizontal width of the first electrode.

2. The semiconductor package according to claim 1,
wherein the wiring structure further includes:
a first insulating layer, wherein the first surface of the wiring structure includes a lower surface of the first insulating layer; and
a second insulating layer above the first insulating layer, and
wherein the first section of the first electrode is disposed between the first insulating layer and the second insulating layer; and
wherein the second section of the first electrode penetrates the first insulating layer and contacts the first conductive pillar.

3. The semiconductor package according to claim 2, wherein
the first conductive pillar electrically connects the first solder layer to the second section of the first electrode.

4. The semiconductor package according to claim 3, wherein the first conductive pillar has a horizontal width less than the horizontal width of the second section of the first electrode.

5. The semiconductor package according to claim 3,
wherein the first section of the first electrode includes:
a first conductive layer; and
a first barrier layer between the first conductive layer and the first insulating layer, and
wherein the second section of the first electrode includes:
the first conductive layer; and
the first barrier layer between the first conductive layer and the first conductive pillar.

6. The semiconductor package according to claim 5, wherein the first conductive pillar includes:
a second conductive layer; and
a second barrier layer between the second conductive layer and the second section of the first electrode.

7. The semiconductor package according to claim 6, wherein the first barrier layer extends between the first conductive layer of the second section of the first electrode and the second barrier layer.

8. The semiconductor package according to claim 3, wherein
the second section of the first electrode comprises an annulus shape, and
the first conductive pillar has a horizontal width less than the outer diameter of the second section of the first electrode.

9. The semiconductor package according to claim 8, wherein the second section of the first electrode further comprises at least one of a circular shape or a polygonal shape inside the annulus shape.

10. The semiconductor package according to claim 2, further comprising:
second and third electrodes on the second surface of the wiring structure,
wherein the wiring structure further includes a third insulating layer on the second insulating layer,
wherein the second and third electrodes penetrate the third insulating layer, and
wherein the third electrode is aligned in the recessed area of the second surface of the wiring structure.

11. The semiconductor package according to claim 10, further comprising:
a second bump between the semiconductor chip and the second electrode; and
a third bump between the semiconductor chip and the third electrode, the third bump having a height greater than the height of the second bump.

12. The semiconductor package according to claim 11, wherein:
the second bump includes a second solder layer and a second conductive pillar between the second solder layer and the semiconductor chip,
the third bump includes a third solder layer and a third conductive pillar between the third solder layer and the semiconductor chip, and
the third conductive pillar has a height greater than the height of the second conductive pillar.

13. A semiconductor package comprising:
a wiring structure having a first surface and a second surface that faces away from the first surface, the wiring structure including a first insulating layer, a second insulating layer between the first insulating layer and the second surface, and a first electrode between the first insulating layer and the second insulating layer, wherein the first surface of the wiring structure includes the lower surface of the first insulating layer;
a first bump on the first surface of the wiring structure;
a semiconductor chip over the second surface of the wiring structure; and
a second bump between the wiring structure and the semiconductor chip,
wherein the first electrode penetrates through the first insulating layer and contacts the first bump,
wherein the first electrode includes a first section that overlaps the first insulating layer and a second section that does not overlap the first insulating layer,
wherein the second section of the first electrode comprises a ring shape,
wherein the first bump includes a first conductive pillar on the first electrode and a first solder layer on the first conductive pillar,
wherein the first conductive pillar electrically contacts the second section of the first electrode, and
wherein the first conductive pillar has a horizontal width less than the outer diameter of the second section of the first electrode.

14. The semiconductor package according to claim 13, wherein the second section of the first electrode further comprises at least one of a circular shape or a polygonal shape inside the ring shape.

15. The semiconductor package according to claim 13,
wherein the first section of the first electrode includes:
a first conductive layer; and
a first barrier layer between the first conductive layer and the first insulating layer, and
wherein the second section of the first electrode includes:
the first conductive layer; and
the first barrier layer between the first conductive layer and the first conductive pillar.

16. The semiconductor package according to claim 15, wherein the first conductive pillar includes:
a second conductive layer; and
a second barrier layer between the second conductive layer and the first electrode.

17. The semiconductor package according to claim 16, wherein the first barrier layer extends between the first conductive layer of the second section of the first electrode and the second barrier layer.

18. The semiconductor package according to claim 13, further comprising:
a second electrode on the second surface of the wiring structure,
wherein the wiring structure further includes a third insulating layer on the second insulating layer,
wherein the second electrode penetrates the third insulating layer, and
wherein the second bump electrically contacts the second electrode.

19. A semiconductor package comprising:
a package substrate;
a wiring structure disposed on the package substrate, wherein the wiring structure includes a first electrode and has a first surface and a second surface that faces away from the first surface;
a first bump disposed between the first surface of the wiring structure and the package substrate, wherein the first bump contacts the first electrode; and
a semiconductor chip over the second surface of the wiring structure,
wherein the second surface of the wiring structure includes a recessed area that overlaps the first electrode,
wherein the first electrode includes a first section and a second section, the first section of the first electrode is disposed between the first surface of the wiring structure and the second surface of the wiring structure, and the second section of the first electrode has a lower surface that is included in the first surface of the wiring structure,
wherein the first bump includes a first conductive pillar on the first surface of the wiring structure and a first solder layer on the first conductive pillar, and
wherein the horizontal width of the first conductive pillar is less than the horizontal width of the first electrode.

20. The semiconductor package according to claim 19,
wherein the wiring structure further includes:
a first insulating layer, wherein the first surface of the wiring structure includes the lower surface of the first insulating layer; and
a second insulating layer above the first insulating layer, and
wherein the first electrode is disposed between the first insulating layer and the second insulating layer,
wherein the first section of the first electrode overlaps the first insulating layer, and the second section of the first electrode does not overlap the first insulating layer,
wherein the first electrode penetrates through the first insulating layer such that the second section of the first electrode electrically contacts the first conductive pillar, and
the first conductive pillar has a horizontal width less than the horizontal width of the second section of the first electrode.
